Europäisches Patentamt

European Patent Office

Office européen des brevets

(11) Publication number: **0 363 134**
**A1**

## (12) EUROPEAN PATENT APPLICATION

(21) Application number: 89310074.3

(51) Int. Cl.5: **H01L 21/285** , **H01L 21/60**

(22) Date of filing: 02.10.89

(30) Priority: 03.10.88 US 252844
15.08.89 US 394388

(43) Date of publication of application:
**11.04.90 Bulletin 90/15**

(84) Designated Contracting States:
**BE DE ES FR GB IT NL SE**

(71) Applicant: THE BOC GROUP, INC.
575 Mountain Avenue
Murray Hill New Jersey 07974(US)

(72) Inventor: Berger, Henry
1400 Virginia Avenue
Durham North Carolina 27705(US)

(74) Representative: Wickham, Michael et al
c/o Patent and Trademark Department The
BOC Group plc Chertsey Road
Windlesham Surrey GU20 6HJ(GB)

(54) **Formation of refractory metal silicide layers.**

(57) An improved method for producing a semiconductor structure which comprises a refractory metal silicide layer on a silicon semiconductor substrate includes the step of depositing a layer of refractory metal on a silicon substrate in the presence of nitrogen. The substrate is heated to a temperature and for a time sufficient to form the silicide by reaction between the refractory metal and the substrate. The (partial) pressure of nitrogen is insufficient for nitrogen impregnating the refractory metal layer during the deposition step then to form a layer of refractory metal nitride during the heating. This (partial) pressure generally does not exceed 6 x $10^{-6}$ torr. Deposition of the layer of refractory metal may be carried out in the presence of a very dilute mixture of nitrogen and an inert gas. Preferred mixtures contain less than about 1 percent by volume of nitrogen.

FIG. I

## FORMATION OF REFRACTORY METAL SILICIDE LAYERS

The present invention pertains to an improvement in the field of semiconductor manufacturing. More particularly, this invention relates to an improved process for preparing layers of refractory metal silicide on semiconductor substrates.

Polycrystalline silicon (polysilicon) and aluminum are the principal materials used to form connections to insulating gate field effect transistor (IGFET) integrated circuits. Refractory metal silicides are conventionally utilised as an over layer to lower the electrical contract resistance of IGFET gate structures (polysilicon) and doped silicon source and drain regions which are typically connected via aluminium lines.

The formation of refractory metal silicide structures in IGFET device fabrication are termed "polycide" where the silicide patterned layer is self-aligned to polysilicon gate regions or "salicide" where the patterned silicide layer is self-aligned to both gate regions and adjacent source and drain regions. In the formation of either structure, a layer of a refractory metal, preferably titanium, is deposited under low pressure on an IGFET device structure and annealed or sintered in an ambient atmosphere, usually nitrogen, to convert the refractory metal to the silicide. The presence of oxygen contaminants in the ambient gas during the annealing step is known to cause problems, particularly when the refractory metal is titanium since it readily reacts with oxygen to form oxides. These titanium oxides have high resistance and interfere with subsequent etch steps necessary to form a patterned layer.

A method for depositing oxygen-free titanium silicide layers by vacuum evaporation has been described in S. Ahmad et al., "A Simple Method of Depositing Oxygen-Free Titanium Silicide Films Using Vacuum Evaporation," Thin Solid Films, 143, pp 155-162 (1986). The method involves forming a composite film having alternating layers of titanium and silicon, and then overcoating the composite film with a thick protectant layer of silicon to prevent oxygen contamination during the annealing step.

An oxidation-resistant, self-aligned titanium silicide process has been described in H-H. Tseng et al., "A New Oxidation-Resistant Self-Aligned TiSi2 Process", IEEE Electron Device Letters, Vol. Edl. 7, No. 11, pp 623-624 (1986). The process involves forming a thin, amorphous, protective silicon layer over the titanium layer.

Lin et al., in "An Environment-Insensitive Trilayer Structure for Titanium Silicide Formation", Solid State Science and Technology, pp 2386-2389, (November 1986), describe forming a trilayer structure consisting of a top insulating silicon film, a middle buffering molybdenum film and a bottom titanium film. Residual oxidants and gaseous impurities are said to be blocked from entering the titanium film by the upper silicon layer.

A two-step method for preparing a titanium nitride diffusion barrier between an aluminum layer and a silicon substrate has been described in C.Y. Ting; "TiN Formed by Evaporation as a Diffusion Barrier between Al and Si", J. Vac. Sci. Technol., 21 (1), May/June, pp 14-16 (1982). The method involves evaporating a thin layer of titanium onto a silicon substrate followed by a layer of titanium doped with nitrogen. Annealing produces a composite film of titanium nitride/titanium silicide on the substrate. It is essential to the disclosed method that there is sufficient nitrogen in the titanium being deposited so that a layer of titanium nitride is formed on the substrate during annealing. The composite film is said to form an effective diffusion barrier between the silicon substrate and an overlying layer of aluminum to prevent the formation of aluminum "spikes" which can degrade junction regions of the device during subsequent processing and/or device operation.

The use of titanium nitride (TiN) diffusion barrier layers has also been shown to be important in meeting metal oxide semiconductor field effect transistor (MOSFET) device requirements, see C.Y. Ting et al., "The Use of TiSi2 in a Self-Aligned Silicide Technology", Proceedings of the First International Symposium on VLSI Science and Technology, pp 224-231 (July, 1982).

Koh, United States Patent No. 4,567,058, discloses a method for reducing lateral diffusion of silicon into titanium during the titanium to titanium silicide coversion (annealing) step by carrying out the conversion in an ambient atmosphere of ultrapure nitrogen. It is stated that the conversion in the nitrogen ambient is much slower than in the previously used argon ambient, thus affording better control of the process thereby minimising silicon diffusion.

Thus, an overlayer of silicon has been utilised to reduce the harmful effect of oxygen contaminants during the annealing step in silicide forming processes. The formation of a layer of titanium nitride has been suggested for protection against spiking from an overlying layer of aluminum, but not as a protectant against oxygen contaminants during the annealing step. Further, the presence of these layers on the substrate adds to the cost of the process, primarily by requiring additional alignment process steps and can represent an additional source of contamination. Accordingly, there is a need for an improved process which would reduce the harmful effect of oxygen residues and other contaminants in the ambient annealing environment in silicide formation. Such a process, which reduces the sensitivity of refractory silicides to oxidants, improves the yield of the silicide process and reduces the cost of semiconductor manufacturing is provided in accordance with this invention.

This invention provides a method for producing a semiconductor structure comprising a refractory metal silicide layer on a silicon semiconductor substrate comprising the steps of depositing a layer of a refractory metal on the substrate in the presence of nitrogen, and heating the resulting structure to a temperature and for a time sufficient to cause reaction between the refractory metal and the substrate to form the refractory metal silicide, wherein the pressure (or partial pressure) of nitrogen is insufficient for nitrogen impregnating the refractory metal layer during the deposition step then to form a layer of refractory metal nitride during said heating.

The pressure (or partial) pressure of nitrogen will normally not exceed $6 \times 10^{-6}$ torr. The amount of nitrogen introduced into the refractory metal film will lightly dope it and render it resistant to oxygen contamination during subsequent heating (i.e. annealing), yet is insufficient to produce a layer of refractory metal nitride upon annealing. The nitrogen may form part of a mixture with an inert gas or may be used alone.

The invention will now be described by way of example with reference to the accompanying drawings.

FIGURE 1 is a schematic diagram of the reactor system.

FIGURE 2 is a graph comparing the effect of varying the gaseous composition of the annealing ambient on the normalised sheet resistance of titanium silicide layers which were prepared without nitrogen.

FIGURE 3 is a graph comparing the effect of varying the gaseous composition of the annealing ambient on the normalised sheet resistance of titanium (N) silicide layers which were prepared with impregnation of the layer with nitrogen prior to annealing.

Applicant has found that the single step of depositing a layer of refractory metal on a substrate in the presence of a (partial) pressure of nitrogen well below that which will saturate the refractory metal with nitrogen, thereby producing a layer of refractory metal nitride upon annealing, will result in a layer of refractory metal lightly doped with nitrogen. The lightly doped refractory metal layer formed by the process according to the invention is significantly less sensitive than an undoped layer to oxidant contaminants in the atmosphere during annealing to form the refractory metal silicide. Applicant has found that it is possible to dope lightly a refractory metal layer with nitrogen to obtain resistance to oxygen contaminants in the annealing step without greatly increasing the resistance of the layer as would be the case were it saturated with nitrogen. The nitrogen dissolved or impregnated in the metal layer may compete with oxygen for titanium during the annealing step to form a titanium nitride complex, which has a lower resistance than titanium oxide, thereby resulting in a metal silicide layer having very low electrical resistance. Hence, since the refractory metal layer formed in accordance with the subject invention is resistant to oxygen contamination, the conventional high gas purity requirements for the annealing atmosphere may be somewhat reduced. Moreover, the subject process is advantageous in that it does not saturate the refractory metal layer with nitrogen which would cause an increase in the resistance thereof.

In accordance with the invention, a layer of refractory metal is deposited on a silicon substrate in the presence of amounts of nitrogen substantially lower than previously thought necessary to protect the layer from oxygen contaminants during annealing of the layer to form the silicide. It has been found that the same protective effect can be achieved by depositing the layer of refractory metal in the presence of very dilute amounts of nitrogen as a mixture with an inert gas which helps to control partial pressure of the nitrogen to the desired level. The partial pressure of nitrogen and the deposition rate of the refractory metal determine the amount of nitrogen incorporated into the layer.

The purity specifications of the nitrogen and the inert gas employed in the present invention normally exceed the purity specifications of the refractory metal and the silicon substrate employed in the silicide forming process. Accordingly, the inert gas can also be used to minimise the concentrations of extraneous contaminants in the vacuum system arising from outgassing and leaks. It is also contemplated within the subject process to include an inert gas sweep step before and after deposition of the layer refractory metal and nitrogen.

The silicon semiconductor substrates useful in the present invention are those substrates which are well known to the skilled artisan to possess desired processing properties, and are stable and compatible with integrated circuit processes. Suitable semiconductor substrates include monocrystalline (single crystal) silicon, polycrystalline silicon (polysilicon), silicon dioxide, and the like. The electrical characteristics of the above substrates, especially the monocrystalline silicon substrate, are commonly altered by doping the substrate with such well known dopants as arsenic, phosphorus, boron, germanium and mixtures thereof. Other suitable semiconductor substrates include compound semiconductors such as gallium arsenate, cadmium telluride and the like. Preferred substrates for the subject process are doped monocrystalline silicon, polycrystalline silicon and silicon dioxide.

The refractory metals useful in the present invention are those metals which form silicides having lower electrical resistance than doped polysilicon and which are compatible with current integrated circuit processes. Suitable refractory metals include molybdenum, tungsten, tantalum, titanium, palladium and the like. Because the resistivity of its silicide is lower than the other metal silicides, titanium is the preferred refractory metal for the subject process.

It is recognized that refractory metal silicides may be formed by a number of methods. In one method, the refractory metal layer is deposited onto a silicon or polysilicon substrate and is converted to a refractory silicide during the annealing step. In another method, a composite layer of refractory metal and silicon is codeposited onto a wafer substrate in a particular ratio and is converted into a silicide during the annealing step. In the latter method, it is not necessary that the underlying substrate be silicon or polysilicon since it contributes very little silicon to the silicide formation. The refractory metal may be deposited on the semiconductor substrate by such well known techniques as vacuum evaporation, sputtering and chemical vapor deposition, with sputtering being preferred.

In conventional processes wherein a barrier layer is formed to protect doped silicon against aluminum "spiking", the amount of nitrogen in the deposition ambient is so high that the refractory metal layer is saturated with nitrogen and a layer of metal nitride is formed during annealing. In contrast, the amount of nitrogen present during the refractory metal depositing in the present invention is significantly lower than conventionally employed, yet is effective to protect the metal layer against oxygen contaminants in the annealing atmosphere. Moreover, the process of the present invention forms a single layer of refractory metal lightly doped with nitrogen which is converted to a metal silicide layer during annealing.

As previously stated, the amount of nitrogen present during deposition of the refractory metal layer in the subject process is dependent to an extent on the system being utilised as well as the deposition rate of the metal since that has a direct influence on the amount of nitrogen trapped therein. In general, the pressure of nitrogen, utilised alone or in admixture with an inert gas, in the metal depositing step is maintained at or below about $6 \times 10^{-6}$ torr, preferably between about $1 \times 10^{-6}$ torr and $6 \times 10^{-6}$ torr.

The mixtures of nitrogen and inert gas useful in the present invention can vary over a wide range, i.e. from about 90 percent to about 0.1 percent by volume of nitrogen with the partial pressure of nitrogen being as given above. It is preferred to utilise the inert gas to achieve and control very dilute levels of nitrogen in the ambient during refractory metal deposition thereby producing the desired level of nitrogen doping in the refractory metal layer. The resulting ambient preferably contains from about 0.1 to 1.0, more preferably from about 0.1 to 0.2, percent by volume of nitrogen.

The inert gases useful in the present invention are gases which do not react with the refractory metals in either the deposition or annealing steps. These inert gases may vary depending upon the particular refractory metal employed. Suitable inert or noble gases include helium, argon, krypton, xenon and mixtures thereof. The preferred inert gases are argon, helium and mixtures thereof.

The present invention may be used in a self-aligned silicide (salicide) method. In this method, passivating oxide layers are utilised to isolate gate regions of the device from source/drain junctions. The entire upper surface of the structure is then coated with a layer of refractory metal, e.g. titanium, and sintered or annealed in an ambient atmosphere of a selected gas. Since the oxide layer prevents silicide formation, only the titanium deposited over the exposed surface of the polysilicon and doped silicon is converted into titanium silicide. The titanium deposited over the passivating oxide layer remains metallic titanium. The metallic titanium is then selectively etched to form a patterned titanium silicide layer with the edges thereof self-aligned to the edges of the passivating oxide layer.

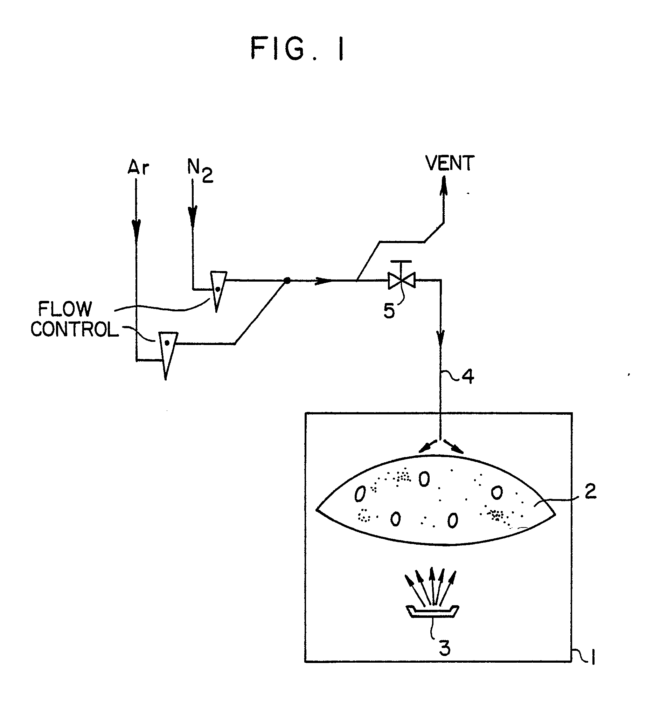

FIG. 1 is a schematic diagram of a typical metal evaporation reactor system useful for performing the process of the present invention. The reactor system includes a vacuum chamber 1 with a substrate holder 2 and a resistive heated titanium boat 3 disposed therein with the titanium boat disposed away from the substrate holder and normal to the substrate. The substrate holder also includes a shutter (not shown) which may be open or closed to control access of the titanium vapor to the substrate. The vacuum chamber includes a gas inlet/outlet line 4 with a high vacuum throttle valve 6 for introducing nitrogen or a mixture thereof with an inert gas from suitable source (not shown) into the chamber and for evacuating gases from the chamber via a vacuum (not shown).

In a typical example of a metal evaporation process of the present invention, the steps that are followed are as follows:

(a) a silicon wafer substrate and a resistive titanium evaporation source are loaded into the vacuum system;

(b) the gas line connecting the vacuum pump to the vacuum system is opened to lower the pressure in the vacuum system to the base pressure of approximately between 1-10 x $10^{-7}$ torr, preferably about 6 x $10^{-7}$ torr;

(c) the vacuum system is purged or backfilled with nitrogen from the gas line to a partial pressure (pp) of between about 1-6 x $10^{-6}$ mbar, preferably about 6 x $10^{-6}$ m bar;

(d) dummy titanium evaporation is begun with the shutter over the silicon wafer closed;

(e) nitrogen infused titanium, Ti(N) is evaporated onto the silicon wafer with the shutter over the silicon wafer opened, maintaining the partial pressure of nitrogen at about 6 x $10^{-6}$ torr; the Ti(N) evaporation rate is between about 10 and 15 Angstroms/second, preferably about 14 Angstroms/second;

(f) the shutter over the silicon wafer is closed and the titanium evaporation is terminated while maintaining the nitrogen partial pressure of the vacuum system through venting steps with nitrogen from the gas line; and

(g) heating the substrate with the layer of refractory metal to a temperature and for a time sufficient to cause reaction between the refractory metal and the substrate to form the silicide.

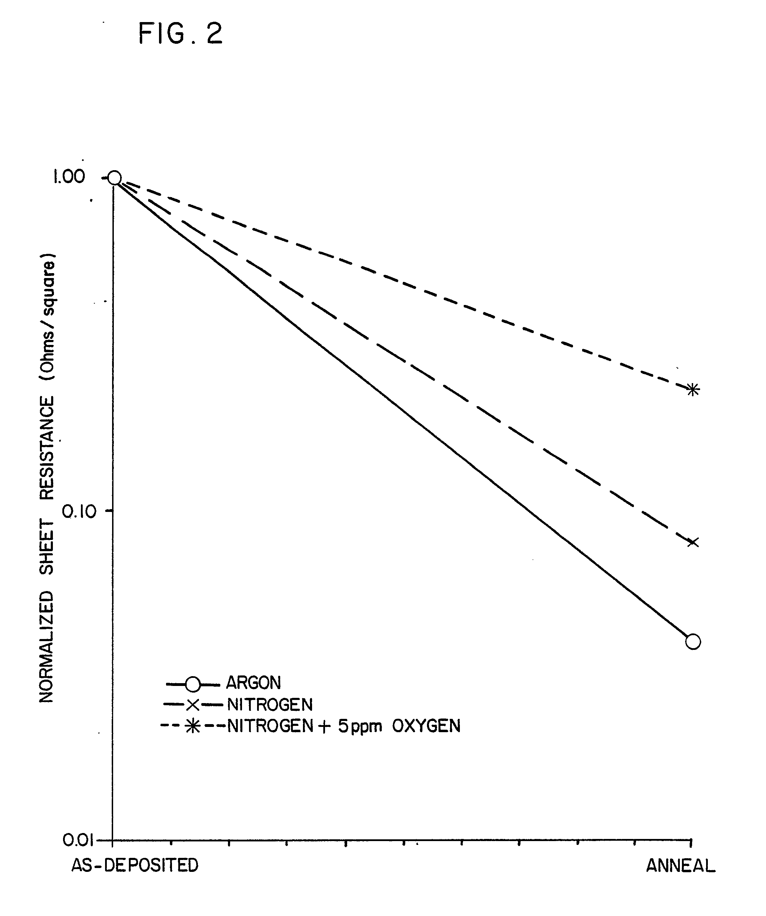

FIG. 2 shows the effect of varying the gaseous composition of the annealing ambient on the normalised sheet resistance of the titanium silicide layers which were formed as described above but without a nitrogen ambient. The sheet resistance values (ohms/square) in FIG. 2 are normalised by the sheet resistance value of the "as-evaporated" Ti layers (abscissa). FIG. 2 shows that, as the ambient atmosphere in the annealing step (800° C., 35 minutes) is changed from argon, to nitrogen, to nitrogen with 5 parts per million (ppm) of oxygen, the sheet resistance value of the annealed film (ordinate) rises accordingly. This upward trend in resistance values is well known and is considered to be the result of titanium oxide/titanium nitride film formation on top of the silicide. Accordingly, the electrical properties of the silicide layer formed without impregnating the metal layer with nitrogen during the deposition step are shown to be sensitive to and dependent upon the annealing ambient.

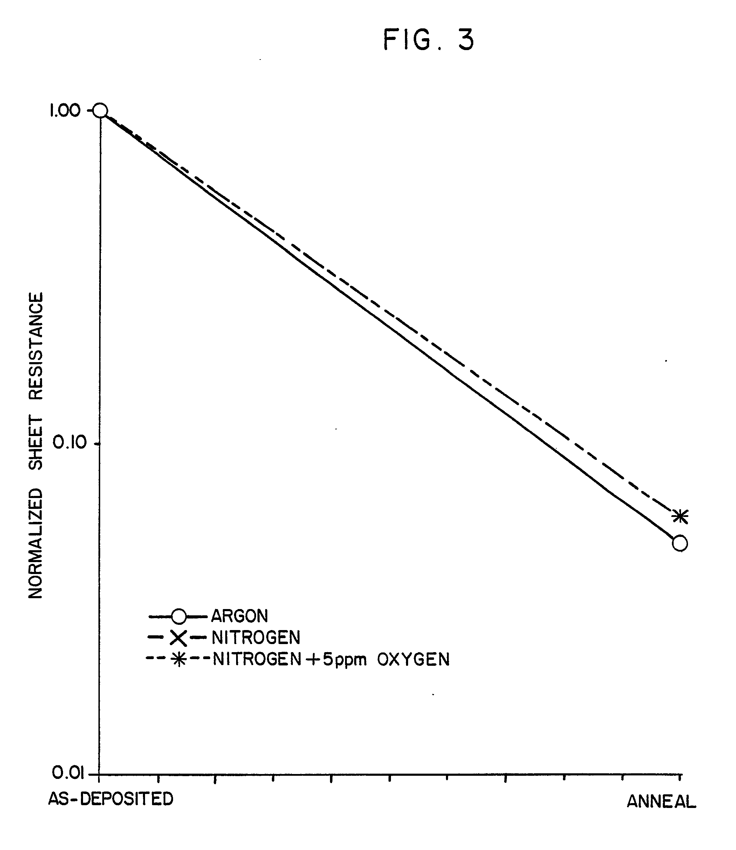

FIG. 3 shows the effect of varying the gaseous composition of the annealing ambient on the normalised sheet resistance of titanium(N) silicide layers which were formed according to the steps outlined about. The sheet resistance values (ohms/square) in FIG. 3 are normalised by the sheet resistance value of the "as-evaporated" Ti layers (abscissa). FIG. 3 shows that, as the ambient atmosphere in the annealing step (800° C., 35 minutes) is changed from argon, to nitrogen, to nitrogen with 5 parts per million (ppm) of oxygen, the sheet resistance value of the annealed layer (ordinate) is relatively constant. These constant resistance values are a surprising difference from the electrical resistances values shown in FIG. 2.

Accordingly, the electrical properties of the silicide layers formed after lightly impregnating the metal layer with nitrogen during the deposition step were relatively stable and were not significantly dependent upon the annealing ambient.

## Claims

1. A method for producing a semiconductor structure comprising a refractory metal silicide layer on a silicon semiconductor substrate comprising the steps of depositing a layer of a refractory metal on the substrate in the presence of nitrogen, and heating the resulting structure to a temperature and for a time sufficient to cause reaction between the refractory metal and the substrate to form the refractory metal silicide, wherein the pressure (or partial pressure) of nitrogen is insufficient for nitrogen impregnating the refractory metal layer during the deposition step then to form a layer of refractory metal nitride during said heating.

2. A method as claimed in Claim 1, wherein said pressure (or partial pressure) does not exceed 6 x $10^{-6}$ torr.

3. A method as claimed in Claim 1 or Claim 2, in which the layer of refractory metal is deposited in the presence of nitrogen alone.

4. A method as claimed in Claim 1 or Claim 2, in which the layer of refractory metal is deposited in the presence of a mixture of nitrogen and an inert gas.

5. A method as claimed in claim 4, in which the mixture contains no more than 1% by volume of nitrogen.

6. A method as claimed in Claim 5. in which the mixture contains from 0.1 to 0.2% by volume of nitrogen.

7. A method as claimed in any one of the preceding claims, wherein the nitrogen partial pressure is in the range 1 x $10^{-6}$ torr to 6 x $10^{-6}$ torr.

8. A method as claimed in any one of the preceding claims in which the refractory metal is titanium.

9. A method as claimed in any one of the preceding claims, additionally including the steps of:

(a) mounting the substrate in a reactor; and

(b) reducing the pressure in the reactor to a suitably low pressure prior to commencing said deposition.

# FIG. 1

FIG. 2

# FIG. 3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A,D | JOURNAL OF VACUUM SCIENCE & TECHNOLOGY, vol. 21, no. 1, May/June 1982, pages 14-18, American Vacuum Society; C.Y. TING: "TiN formed by evaporation as a diffusion barrier between Al and Si" * Whole article * | 1 | H 01 L 21/285<br>H 01 L 21/60 |
| A | EP-A-0 264 692 (IBM) | | |
| A | EP-A-0 209 196 (PHILIPS) | | |

TECHNICAL FIELDS
SEARCHED (Int. Cl.5)

H 01 L

The present search report has been drawn up for all claims

| Place of search | Date of completion of the search | Examiner |
|---|---|---|
| THE HAGUE | 22-12-1989 | PHEASANT N.J. |